# EUROPEAN PATENT APPLICATION

(11) **EP 2 922 105 A1**
(43) Date of publication of application: **23.09.2015**
(21) Application number: 15159812.5
(22) Date of filing: 19.03.2015
(51) Int. Cl.: H01L 37/00

(54) **Thermoelectric conversion device**

(30) Priority: 19.03.2014 JP 2014057235
(71) Applicant: Kabushiki Kaisha Toshiba, Tokyo 105-8001 (JP)
(72) Inventor: Yuasa, Hiromi, Tokyo, 105-8001 (JP); Kado, Masaki, Tokyo, 105-8001 (JP)
(74) Representative: Granleese, Rhian Jane

(57) **Abstract**

A thermoelectric conversion device (100) includes a substrate (10); a non-magnetic metal layer (40); and an insulating ferromagnetic layer (20) which is provided between the substrate (10) and the non-magnetic metal layer (40), has magnetization fixed in one in-plane direction, and is composed of a hard magnetic body. A metal ferromagnetic layer (30) may also be present.

## Description

### CROSS REFERENCE TO RELATED APPLICATION(S)

The application is based upon and claims the benefit of priority from Japanese Patent Application No. 2014-057235 filed on March 19, 2014, the entire contents of which are incorporated herein by reference.

### FIELD

Embodiments of the present invention relate to a thermoelectric conversion device.

### BACKGROUND

As one type of a thermoelectric conversion device, a thermoelectric conversion device using the spin Seebeck effect has been known. According to the reports so far released, an electromotive force is obtained in an environment in which a magnetic field is applied from the outside. However, practically, it is required to generate electric power without application of a magnetic field from the outside.

### BRIEF DESCRIPTION OF THE DRAWINGS

A general configuration that implements the various features of embodiments will be described with reference to the drawings. The drawings and the associated descriptions are provided to illustrate embodiments and not to limit the scope of the embodiments.
Fig. 1 is a diagram illustrating a thermoelectric conversion device according to an embodiment of the present invention.
Fig. 2 is a diagram illustrating the embodiment.
Fig. 3A is a diagram illustrating the embodiment.
Fig. 3B is a diagram illustrating the embodiment.
Fig. 4A is a diagram illustrating the embodiment.
Fig. 4B is a diagram illustrating the embodiment.
Fig. 5A is a diagram illustrating the embodiment.
Fig. 5B is a diagram illustrating the embodiment.
Fig. 6 is a diagram illustrating the embodiment.
Fig. 7 is a diagram illustrating the embodiment.
Fig. 8 is a diagram illustrating the embodiment.

### DETAILED DESCRIPTION

Referring to the following drawings, each embodiment of the present invention will be described. Similar components in the drawings are marked with like reference numerals. The drawings are schematic or conceptual, the relationship between the thickness and the width of each portion, the size ratio between the portions, and the like are not necessarily the same as the actual values thereof. Further, the dimensions and the proportions may be illustrated differently among the drawings, even for identical portions.

### (Embodiments)

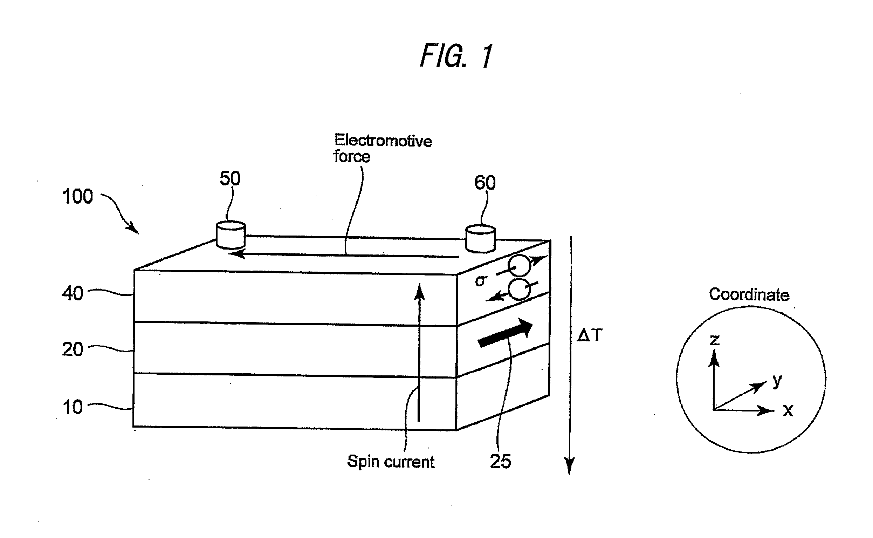

Fig. 1 is a diagram illustrating a thermoelectric conversion device 100. In the thermoelectric conversion device 100, an insulating ferromagnetic layer 20 composed of a ferrite magnet and a non-magnetic metal layer 40 are provided on a substrate 10 in this order. These may be defined as a laminated body. Terminals 50 and 60 are further provided on the non-magnetic metal layer 40.

The operation principle of the thermoelectric conversion device 100 will be described. The thermoelectric conversion device 100 can generate electric power using the spin Seebeck effect.

When a temperature gradient ΔT is applied to the insulating ferromagnetic layer 20 and a metal ferromagnetic layer 30 between the substrate 10 and the non-magnetic metal layer 40, a difference is generated between the distribution of up-spin electrons and the distribution of down-spin electrons of the insulating ferromagnetic layer 20. This phenomenon is referred to as the spin Seebeck effect, and the difference between the distribution of up-spin electrons and the distribution of down-spin electrons generated at this time is referred to as spin voltage. The spin voltage generated in the insulating ferromagnetic layer 20 is propagated to the non-magnetic metal layer 40 as a spin current. The spin current is a current caused by the difference between the distribution of up-spin electrons and the distribution of down-spin electrons and is not a flow of electric charge. When the spin current is propagated into the non-magnetic metal layer 40, by an inverse spin hall effect, an electric current which is a flow of electric charge flows in a direction orthogonal to the spin current and magnetization 25 of the insulating ferromagnetic layer 20 to generate an electromotive force. Therefore, the thermoelectric conversion device 100 generates electric power.

It is preferable that the substrate 10 and the insulating ferromagnetic layer 20, and the insulating ferromagnetic layer 20 and the non-magnetic metal layer 40 be brought into contact with each other. Since each layer is brought into contact with each other in this manner, the spin current can be propagated to the non-magnetic metal layer 40 without leakage.

As the substrate 10, a flexible substrate can be used to generate electric power in a relatively large area using all heat generating surfaces. The substrate 10 preferably has flexibility in which the Young's modulus is 10 or less. For the substrate 10, polyimide, polypropylene, nylon, polyester, parylene, rubber, biaxially stretched polyethylene-2, 6-naphthalate, or modified polyamide can be used. When flexibility is not required, a substrate made of Si, glass, sapphire, or the like can be used. When the insulating ferromagnetic layer 20 has a thickness of at least 1 µm, the thermoelectric conversion device 100 can be used instead of the substrate 10.

For the non-magnetic metal layer 40, materials having a large spin hall angle are suitably used, and Pt, Ta, and W are used. It is preferable for Ta to have a cubic crystal structure. This is because the electrical resistivity of cubic α-Ta is lower than that of amorphous Ta. In addition, it is more preferable for Ta to have a tetragonal crystal structure. This is because the spin hall angle is large. The tetragonal Ta is also referred to as β-Ta. The same is applied to a case in which W is used for the non-magnetic metal layer 40, and tetragonal β-W is desirable. When at least one element selected from Hf, W, Ir, Pt, Au, Pb, and Bi is added to the non-magnetic metal layer 40 including Ta, the electromotive force is further improved. In the same manner, when at least one element selected from Hf, Ta, Ir, Pt, Au, Pb, and Bi is added to the non-magnetic metal layer 40 including W, the electromotive force is further improved. These elements are added to the non-magnetic metal layer 40 in an amount of 3 at% or more and 30 at% or less. These elements have a function of increasing a spin orbital interactive action in the non-magnetic metal layer 40 to increase a spin hall angle θ_{SH}. Therefore, the power generation efficiency of the thermoelectric conversion device 100 is improved.

Further, at least one element selected from Fe, Co, Ni, Mn, and Cr may be added to the non-magnetic metal layer 40 including Pt, Ta, or W. These elements are added to the non-magnetic metal layer 40 in an amount of 1 at% or less. The above-described elements may be added together with Hf, W, Ta, Ir, Pt, Au, Pb, and Bi. Since the amount of these elements added is very small, the non-magnetic metal layer 40 maintains non-magnetic properties as a whole. Since these elements are localized in the non-magnetic metal layer 40, these elements have a function of increasing the spin orbital interactive action to increase the spin hall angle θ_{SH}-Therefore, the power generation efficiency of the thermoelectric conversion device 100 is improved. The non-magnetic metal layer 40 detects a spin current and thus, is also referred to as a spin current detection layer.

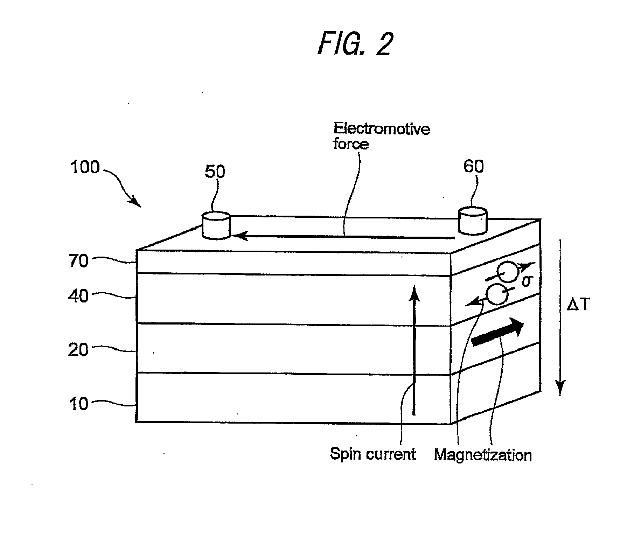

As illustrated in Fig. 2, a protective layer 70 can be provided on the non-magnetic metal layer 40 to prevent oxidation. As the material of the protective layer 70, Pt, Au, and Ru, which are non-oxidative metals, can be used. These materials which are laminated or an alloy thereof can be used.

The direction of the electromotive force will be described. The electromotive force is generated in a cross product direction of the magnetization 25 of the insulating ferromagnetic layer 20 and a temperature difference direction, that is, a spin current direction. Accordingly, in order to extract the electromotive force from the terminals 50 and 60, the magnetization 25 of the insulating ferromagnetic layer 20 is fixed so as to be orthogonal to the temperature difference direction. For example, as illustrated in Fig. 1, axes of coordinates are determined. When a temperature difference is generated in a z direction (lamination direction) of the thermoelectric conversion device 100, the electromotive force is generated in a -x direction if the magnetization 25 is oriented in a +y direction. The temperature difference is generated in a direction of connecting the substrate 10 and the non-magnetic metal layer 40.

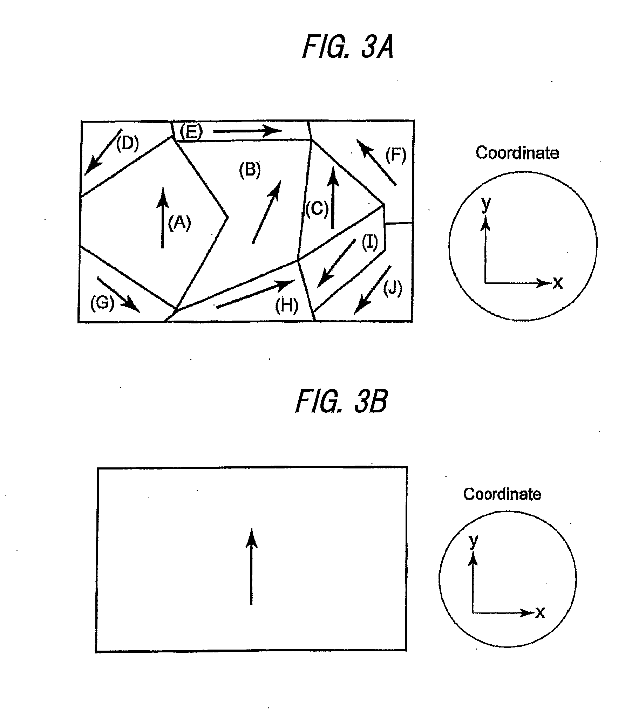

Figs. 3A and 3B are schematic diagrams illustrating the magnetization state of the insulating ferromagnetic layer 20 as seen from the z direction of Fig. 1. Fig. 3A is a diagram in which magnetic domains with magnetizations respectively oriented in different directions are formed in the insulating ferromagnetic layer 20. In this case, magnetizations of magnetic domains (A), (B), and (C) are oriented substantially in the +y direction. Therefore, the electromotive force can be generated in the -x direction. However, magnetic domains (D), (I), and (J) are oriented substantially in the -y direction. Therefore, the electromotive force can be generated in the +x direction, and the electromotive forces from the magnetic domains (A), (B), and (C) are canceled. As illustrated in Fig. 3B, when a single magnetic domain is formed in which the magnetization of the insulating ferromagnetic layer 20 is oriented in one direction, the total magnetization is oriented in the +y direction. Therefore, the electromotive force is also generated over the entire layer in the -x direction, and the greatest electromotive force can be extracted from the terminals 50 and 60. The shape of the magnetic domain is dependent on materials and shapes. Thus, Fig. 3A is just an example.

As described above, in order to effectively extract the electromotive force relative to the temperature difference, a single magnetic domain in which the magnetization 25 of the insulating ferromagnetic layer 20 is oriented in a direction orthogonal to the direction of connecting the terminal 50 to the terminal 60 is preferable.

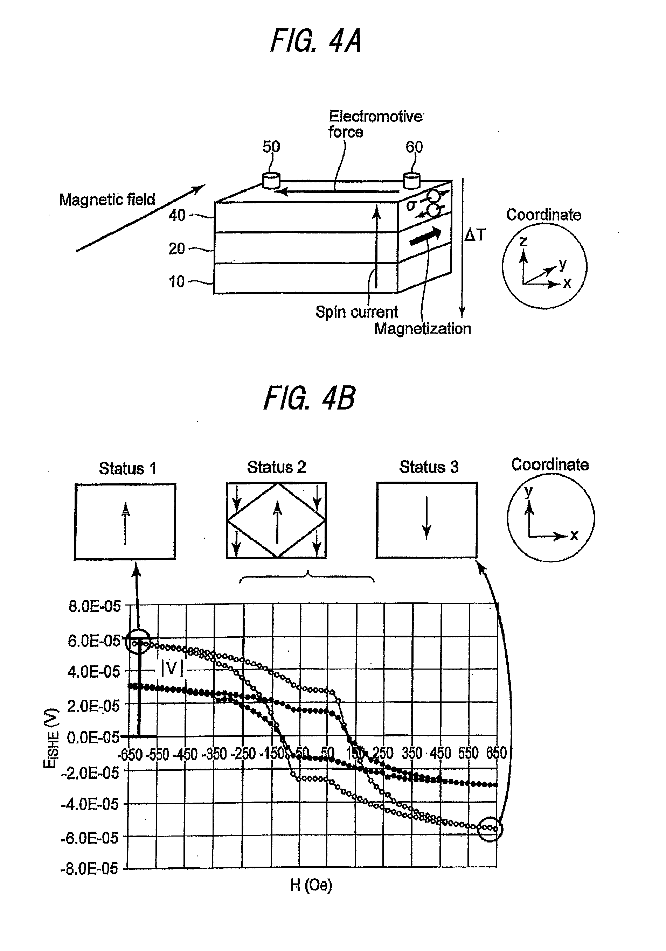

Fig. 4A is a diagram illustrating a technology associated with the thermoelectric conversion device. In order to realize a single magnetic domain in the insulating ferromagnetic layer 20, a magnetic field is applied to the entire thermoelectric conversion device in the y direction from the outside. When a temperature difference is generated in the lamination direction (z direction) of the thermoelectric conversion device and the terminals 50 and 60 are provided in the x direction, an electromotive force |V| is obtained as illustrated in Fig. 4B if the magnetic field is swept in the y direction. In this manner, "Status 1" and "Status 3" are realized and an electromotive force is obtained by the spin Seebeck effect. Here, an electromotive force is generated even in "Status 2" in which there is no external magnetic field. However, there are two problems here. One is that as described above using Fig. 3, the magnetic domain is formed and the value of the electromotive force is smaller than that of "Status 1" or "Status 3".

The other is that as illustrated in Fig. 4B, the magnetization is inverted by an external magnetic field of about 100 Oe and thus, when magnetic noise enters from the outside, the magnetization easily rotates or is easily inverted. Thus, an electromotive force cannot be obtained. In order to avoid the problem, it is necessary to form a single magnetic domain in the insulating ferromagnetic layer 20.

However, when the thermoelectric conversion device is used as a power generation device, it is difficult to apply a magnetic field from the outside continuously. Even when the external magnetic field can be applied, the shape of the power generation device is limited and thus, it is difficult to apply the device for various purposes.

In order to solve the problem, it is effective to form the insulating ferromagnetic layer 20 with a hard magnetic body.

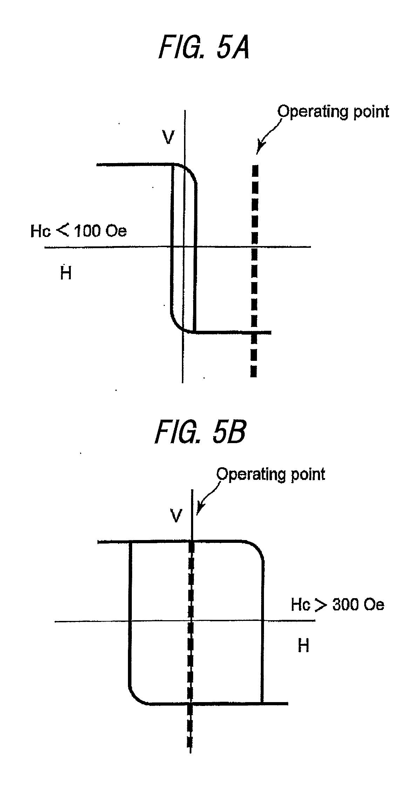

Fig. 5A is a schematic diagram illustrating the electromotive force of the thermoelectric conversion device 100 generated when a soft magnetic material (having a coercivity of 100 Oe or higher) is used for the insulating ferromagnetic layer 20 and the external magnetic field is applied to the insulating ferromagnetic layer 20. Fig. 5B is a schematic diagram illustrating the electromotive force of the thermoelectric conversion device 100 generated when a hard magnetic material (having a coercivity of 300 Oe or higher) is used for the insulating ferromagnetic layer 20 and the external magnetic field is applied to the insulating ferromagnetic layer 20. In Fig. 5A, the time when the external magnetic field is applied and the magnetization of the insulating ferromagnetic layer 20 is aligned in one direction is set as an operating point at which an electromotive force is generated. On the other hand, in Fig. 5B, a state in which the external magnetic field is not applied can be set as an operating point. As illustrated in Fig. 5B, when the coercivity (Hc) is 300 Oe or higher, the magnetization is hardly inverted and thus, a resistance against magnetic noise also increases. The coercivity of ferrite practically increases up to about 4000 Oe, and thus, 4000 Oe is set as an upper limit. When there is any means for realizing a coercivity of 4000 Oe or higher, the means can be also used in the embodiment. Since a coercivity of 300 Oe or higher can be realized with an ideal ferrite magnet, a sufficiently high coercivity can be realized. From the above reasons, in the embodiment, a hard magnetic body referred to as a ferrite magnet can be used for the insulating ferromagnetic layer 20.

As the hard magnetic body, an oxide including at least one element selected from Sr, La, Co, Zn, and Ba and having Fe and oxygen as main components can be used. The main components refer to 25 at% or more of Fe and 55 at% or more of oxygen. For the insulating ferromagnetic layer 20, SrFe₁₂O₁₉, LaFe₁₂O₁₉, LaCo₍ₓ₎Fe₍₁₂₋ₓ₎O₁₉ (here, 0<x<2), Sr_{(y)}La_{(1-y)}Co₍ₓ₎Fe₍₁₂₋ₓ₎O₁₉ (here, 0<x<2, 0<y<1), Sr_{(y)}La_{(i-y)}Zn₍ₓ₎Fe₍₁₂₋ₓ₎O₁₉ (here, 0<x<2, 0<y<1), CoFe₂O₄, or Ni₍ₓ₎Zn₍₁₋ₓ₎Fe₂O₄ (here, 0<x<1) can be used.

In Table 1, the coercivities of some magnetic materials deposited on a thermally oxidized Si substrate are shown. The compositions shown in Table 1 are insulating magnetic layer/non-magnetic metal configurations. Working examples 1 to 3 and Comparative examples 1 to 5 are shown. In addition, in Table 1, soft magnetism and hard magnetism are indicated. In all examples, an insulating magnetic layer and a non-magnetic layer were formed on the thermally oxidized Si substrate by a sputtering method. As seen from Table 1, in Working examples 1 to 3, a coercivity of 300 Oe or higher was obtained. These values satisfy the condition as a hard magnetic material. In a high power sputtering operation, the acceleration voltage of ion beam sputtering was set to 1000 V. In a low power sputtering operation, the acceleration voltage of ion beam sputtering was set to 500 V.

**[Table 1]**

| | Composition | He [Oe] | |
|---|---|---|---|
| Comparative example 1 | Ni-Zn-Fe-0 100nm/Pt 10nm | 100 | Soft magnetism |
| Comparative example 2 | Y₃Fe₅O₁₂ 60nm/Pt 10nm | 5 | Soft magnetism |
| Comparative example 3 | Ni_{0.2}Zn_{0.3}Fe_{2.5}O₄ 3um/Pt 10nm | 25 | Soft magnetism |
| Comparative example 4 | Co₂MnSi 20nm/Pt 10nm | 16 | Soft magnetism |
| Comparative example 5 | Ni₈₁Fe₁₉ 20nm/Pt 10nm | 15 | Soft magnetism |
| Working example 1 | Ni-Zn-Fe-O 100nm/Pt 10nm | 444 | Hard magnetism |
| Working example 2 | Ni-Zn-Fe-O 200nm(high power sputtering)/Pt 10nm | 590 | Hard magnetism |
| Working example 3 | Ni-Zn-Fe-O 200nm/(low power sputtering)Pt 10nm | 445 | Hard magnetism |

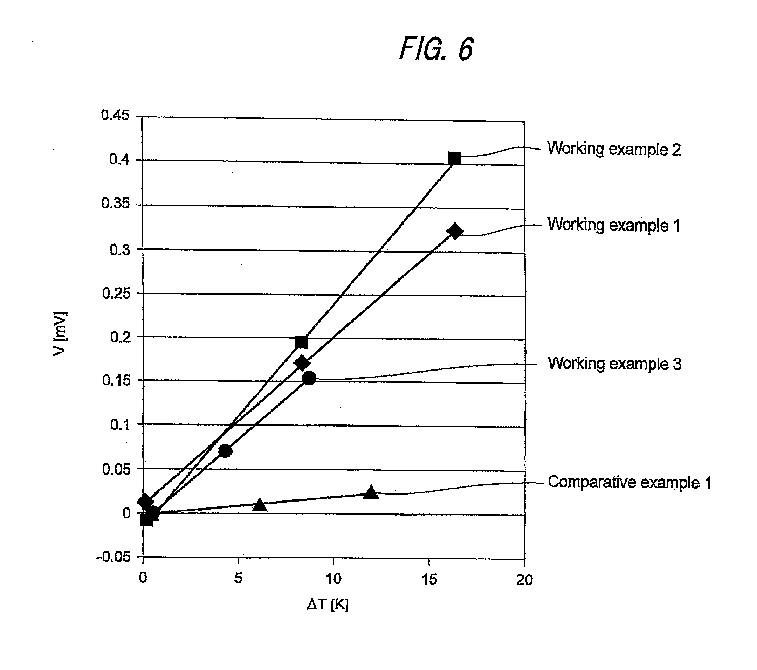

The magnetic bodies of Comparative example 1, and Working examples 1 to 3 were used for the insulating ferromagnetic layer to prepare thermoelectric conversion devices. In Table 2, the results obtained by measuring the spin Seebeck effect without application of the magnetic field to these thermoelectric conversion devices were shown. Fig. 6 illustrates the results obtained by measuring the electromotive forces of these thermoelectric conversion devices. The horizontal axis represents a temperature difference ΔK (K) between the top surface and the bottom surface of the thermoelectric conversion device. The vertical axis represents an electromotive force (mV) obtained between two terminals provided on the non-magnetic metal layer of the thermoelectric conversion device. It is possible to calculate a spin Seebeck coefficient S from the inclination of a graph in Fig. 6.

**[Table 2]**

| | Composition | Coercivity He [Oe] | Spin Seebeck coefficient [µV/Km] | |
|---|---|---|---|---|
| Comparative example 1 | Ni-Zn-Fe-O 100nm/Pt 10nm | 90 | 68 | Soft magnetism |
| Working example 1 | Ni-Zn-Fe-O 100nm/Pt 10nm | 445 | 696 | Hard magnetism |
| Working example 2 | Ni-Zn-Fe-O 200nm(high power sputtering)/Pt 10nm | 590 | 918 | Hard magnetism |
| Working example 3 | Ni-Zn-Fe-O 200nm/(low power sputtering)Pt 10nm | 444 | 671 | Hard magnetism |

In the spin Seebeck effect, a distance between two terminals on the non-magnetic metal layer is proportional to the electromotive force, and thus, an electromotive force per unit length and per unit temperature obtained by dividing the electromotive force by the distance (28 mm) between two terminals is used as a spin Seebeck coefficient.

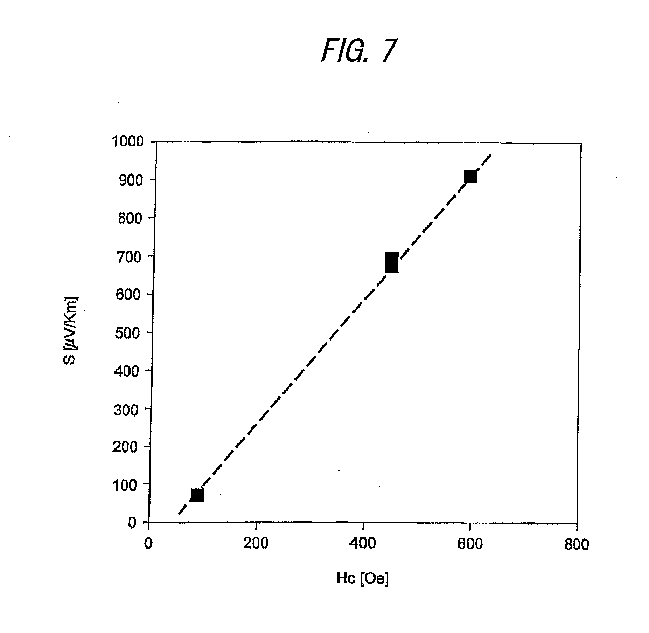

Fig. 7 illustrates the result obtained by summarizing the results in Table 2. It is found that when the coercivity Hc increases, the spin Seebeck coefficient S increases.

From the above, it has been found that the use of the hard magnetic body having a coercivity of 300 Oe or higher in the insulating ferromagnetic layer 20 is effective to stably obtain a great electromotive force.

As Working examples 4 to 9, thermoelectric conversion devices were prepared. In Working examples 4 and 5, the configuration of the thermoelectric conversion device 100 was used.

### (Working example 4)

The ferrite composition used for the insulating ferromagnetic layer 20 was changed. The insulating ferromagnetic layer 20 having a thickness of 200 nm and having a magnetoplumbite type hexagonal crystal structure, such as Sr-Fe-O, La-Fe-O, La-Co-Fe-O, Sr-La-Co-Fe-O, or Sr-La-Zn-Fe-O, was formed on the thermally oxidized Si substrate. In addition, the insulating ferromagnetic layer 20 having a spinel type crystal structure and composed of CoFe₂O₄ was formed on the thermally oxidized Si substrate. Since these layers had a ferrite magnet composition, a high coercivity in a range of 2500 Oe to 4000 Oe was exhibited. Therefore, a resistance against magnetic noise was high and a stable electromotive force was able to be generated.

### (Working example 5)

The thickness of the insulating ferromagnetic layer 20 was changed.

Films of Ni-Zn-Fe-O used for the insulating ferromagnetic layer 20 were prepared to have thicknesses of 10 nm and 20 nm.

The coercivity of the 10 nm film was 300 Oe, and the coercivity of the 20 nm film was 320 Oe.

Next, the thickness was uniformly set to 20 nm and the composition of the insulating ferromagnetic layer 20 was changed. Each coercivity of Sr-Fe-O, La-Fe-O, La-Co-Fe-O, Sr-La-Co-Fe-O, Sr-La-Zn-Fe-O, and CoFe₂O₄ was respectively 1100 Oe, 1150 Oe, 1500 Oe, 1460 Oe, 1130 Oe, and 1340 Oe. Even in Working examples, a sufficiently stable electromotive force was able to be generated.

### (Working example 6)

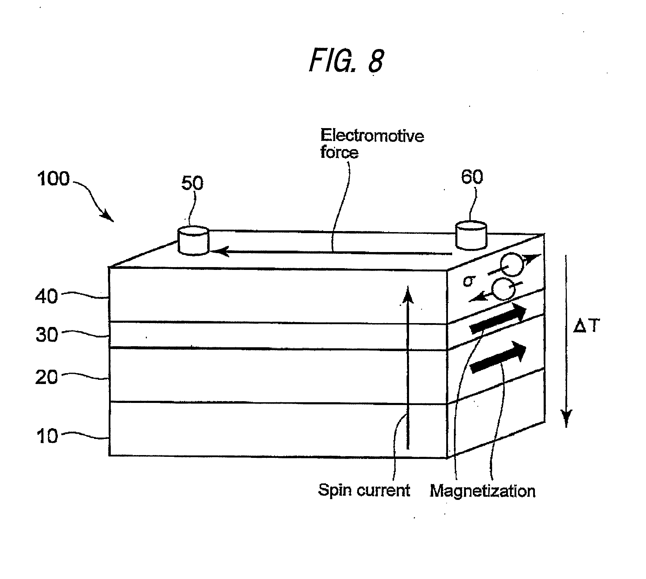

The configuration of the insulating ferromagnetic layer 20 was changed. As illustrated in Fig. 8, the metal ferromagnetic layer 30 was interposed between the insulating ferromagnetic layer 20 and the non-magnetic metal layer 40. The metal ferromagnetic layer 30 is a metal magnetic body including at least one of Fe, Co, Ni, Cr, and Mn. The thickness is in a range of 1 Å to 2 nm. When the thickness of the metal ferromagnetic layer 30 is thick, the electromotive force leaks. Therefore, it is necessary to adjust the thickness according to the specific resistance. When a FeCr alloy film having a thickness of 0.15 nm was used as the metal ferromagnetic layer 30, the electromotive force was increased by 1.5 times relative to the configurations described in Working examples 1 to 5 compared to a case in which the metal ferromagnetic layer 30 was not used. The magnetization of the metal ferromagnetic layer 30 is oriented to the same direction as the magnetization direction of the insulating ferromagnetic layer 20. The metal ferromagnetic layer 30 may be brought into contact with the insulating ferromagnetic layer 20 and the non-magnetic metal layer 40. In this manner, since each layer is brought into contact with each other, the spin current can be propagated to the non-magnetic metal layer 40 without leakage.

Next, a method of preparing the insulating ferromagnetic layer 20 will be described. A crystal structure including a magnetoplumbite type hexagonal crystal structure or a spinel structure can be obtained by setting the temperature of the substrate during film formation to 200°C to 500°C using a sputtering method. At this time, the insulating ferromagnetic layer 20 has a coercivity of 300 Oe or higher.

Additionally, a vacuum deposition method, an electroless deposition method, and a method in which a sintered body is pulverized by ball milling, and the resultant is mixed with a solvent to be applied, can be used.

When the insulating ferromagnetic layer 20 is formed, and then, heat treatment at a temperature of 700°C or higher and 1200°C or lower is performed on the insulating ferromagnetic layer 20, a crystal structure including a magnetoplumbite type hexagonal crystal structure can be obtained. Alternatively, when heat treatment at a temperature of 100°C or higher and 350°C or lower is performed on the insulating ferromagnetic layer 20, a crystal structure including a spinel structure can be obtained. At this time, the insulating ferromagnetic layer 20 has a coercivity of 300 Oe or higher.

In order to form a single magnetic domain in the insulating ferromagnetic layer 20, a magnetic field which is greater than the coercivity is applied thereto and the magnetization is oriented to one direction. When the coercivity of the insulating ferromagnetic layer 20 is 300 Oe, as long as the external magnetic field is 1000 Oe or higher, a single magnetic domain can be formed in the insulating ferromagnetic layer 20. When the external magnetic field is 5000 Oe or higher, a single magnetic domain can be formed reliably in the insulating ferromagnetic layer 20. Further, as the external magnetic field, a pulse magnetic field applied in a short period of time can be used.

Several embodiments of the present invention have been described, but these embodiments are presented as examples only and are not intended to limit the scope of the invention. These novel embodiments can be carried out in various other forms, and various omissions, substitutions, and changes can be made therein without departing from the spirit of the invention. These embodiments and modifications thereof are included in the scope and spirit of the invention and are included in the scopes of the inventions described in the claims and their equivalencies.

## Claims

1. A thermoelectric conversion device comprising:
a substrate;
a non-magnetic metal layer; and
an insulating ferromagnetic layer which is provided between the substrate and the non-magnetic metal layer, has magnetization fixed in one in-plane direction, and is composed of a hard magnetic body.

2. The thermoelectric conversion device according to Claim 1, further comprising:
two terminals which are provided on the non-magnetic metal layer and are provided to separate from each other in a direction orthogonal to the magnetization of the insulating ferromagnetic layer.

3. The thermoelectric conversion device according to Claim 1 or 2, wherein a temperature difference is present in a direction of connecting the substrate and the non-magnetic metal layer.

4. The thermoelectric conversion device according to any one of Claims 1 to 3, further comprising:
a metal ferromagnetic layer which is provided between the insulating ferromagnetic layer and the non-magnetic metal layer.

5. The thermoelectric conversion device according to Claim 4,
wherein magnetization of the metal ferromagnetic layer is oriented to the same direction as a magnetization direction of the insulating ferromagnetic layer.

6. The thermoelectric conversion device according to any one of Claims 1 to 5,
wherein the hard magnetic body has a coercivity of 300 Oe or higher.

7. The thermoelectric conversion device according to any one of Claims 1 to 6,
wherein the hard magnetic body is an oxide including at least one element selected from Sr, La, Co, Zn, and Ba and including 25 at% or more of Fe and 55 at% or more of oxygen.

8. The thermoelectric conversion device according to any one of Claims 1 to 7,
wherein the hard magnetic body is Sr-Fe-O, La-Fe-O, La-Co-Fe-O, Sr-La-Co-Fe-O, Sr-La-Zn-Fe-O, Co-Fe-O, or Ni-Zn-Fe-O.

9. The thermoelectric conversion device according to any one of Claims 1 to 6,
wherein the hard magnetic body is SrFe₁₂O₁₉, LaFe₁₂O₁₉, LaCO₍ₓ₎Fe₍₁₂₋ₓ)O₁₉ (here, 0<x<2), Sr_{(y)}La_{(1-y)}CO₍ₓ₎Fe₍₁₂₋ₓ₎O₁₉ (here, 0<x<2, 0<y<1), Sr_{(y)}La_{(1-y)}Zn₍ₓ₎Fe₍₁₂₋ₓ₎O₁₉ (here, 0<x<2, 0<y<1), CoFe₂O₄, or Ni₍ₓ₎Zn₍ᵢ₁ₓ₎Fe₂O₄ (here, 0<x<1).

10. The thermoelectric conversion device according to any one of Claims 1 to 8,
wherein the hard magnetic body has a magnetoplumbite type hexagonal crystal structure or a spinel crystal structure.
